# EUROPEAN PATENT APPLICATION

(11) **EP 2 475 004 A2**
(43) Date of publication of application: **11.07.2012**
(21) Application number: 11189847.4
(22) Date of filing: 18.11.2011
(51) Int. Cl.: H01L 23/482, H01L 23/492

(54) **Semiconductor package with reduced on-resistance and top metal spreading resistance with application to power transistor packaging**

(30) Priority: 10.01.2011 US 460980 P; 20.07.2011 US 187362
(71) Applicant: International Rectifier Corporation, El Segundo, CA 90245 (US)
(72) Inventor: Burbidge, Rupert, Oxted, Surrey RH8 9JS (GB); Jones, David Paul, Penarth, South Glamorgan CF64 1SE (GB)
(74) Representative: Dr. Weitzel & Partner

(57) **Abstract**

Some exemplary embodiments of a semiconductor package including a semiconductor device having electrodes on opposite major surfaces connectable to a planar support surface without a bondwire and a control electrode disposed in a corner position for reducing top-metal spreading resistance and device on-resistance have been disclosed. One exemplary structure comprises a semiconductor device having a first major surface including a first electrode and a second major surface including a second electrode and a control electrode, wherein the control electrode is disposed in a corner of the second major surface, and wherein the first electrode, the second electrode, and the control electrode are electrically connectable to a planar support surface without a bondwire. The pads of the device may be arranged in a balanced grid to maintain device stability during integration. A minimum gap distance between die pads allows the placement of vias in the planar support surface.

## Description

### RELATED APPLICATIONS

The present application claims the benefit of and priority to a pending provisional application entitled "Reduction of On- Resistance and Top Metal Spreading Resistance in Semiconductor Packaging with Application to Power Transistor Packaging," Serial Number 61/460,980 filed on January 10, 2011. The disclosure in that pending provisional application is hereby incorporated fully by reference into the present application.

### BACKGROUND OF THE INVENTION

### 1. FIELD OF THE INVENTION

The present invention relates generally to semiconductor devices. More particularly, the present invention relates to semiconductor device packaging.

### 2. BACKGROUND ART

Conventional package designs for power devices such as MOSFETs have emphasized ease of customer integration as an important commercial advantage. As such, many power packages, such as the DirectFET® package by International Rectifier Corporation, have utilized a package design positioning a control pad centrally in a shorter dimension of a packaged device die. For example, a power package may include a gate pad positioned centrally in the shorter dimension of a vertical conduction FET. The longitudinal symmetry provided by this package design facilitates the balancing of solder wetting forces on the die pads when mounting to a support surface such as a printed circuit board (PCB). As a result, customers and end users may more readily integrate the packaged power devices with less concern over issues such as die tilt, tombstoning, misalignment, and other integration errors.

Unfortunately, the central positioning of the control pad exhibits several disadvantages. One disadvantage is that the centrally positioned control pad often requires additional space around the control pad to be reserved on the die to conform with best practice design rules for manufacturability and reliability, specifying minimum gaps between die pads and package boundaries. Another disadvantage is that the package exhibits increased top metal spreading resistance due to the central gate position blocking the flow of current, disadvantageously increasing overall device on-resistance.

In the past, such top metal spreading resistance may have only comprised a small percentage of the overall package on-resistance. However, continual developments and refinements in package design have reduced the contribution of other factors to the overall on-resistance of power packages, thereby causing the top metal spreading resistance to be a much larger percentage of the package on-resistance. Thus, reducing the top metal spreading resistance is now a much more urgent problem.

While one proposed solution would be to thicken the top metal layer on the die pads to mitigate the effects of spreading resistance, such a solution would undesirably add cost and increase package height and form factor. Another proposed solution would be to increase the surface area of the source pads. However, such a solution may conflict with best practice design rules specifying minimum pad gaps, as discussed above.

Thus, to meet commercial demands for improved device efficiency and performance, a unique cost-effective solution is needed for reducing the top metal spreading resistance and thereby reducing the overall on-resistance of semiconductor packages, particularly power transistor packages, while still adhering to best practice design rules.

### SUMMARY OF THE INVENTION

A semiconductor package with reduced on-resistance and top metal spreading resistance with application to power transistor packaging, substantially as shown in and/or described in connection with at least one of the figures, and as set forth more completely in the claims.

### BRIEF DESCRIPTION OF THE DRAWINGS

Figure 1A illustrates a perspective view of a conventional semiconductor package.
Figures 1B, 1C, and 1D illustrate perspective views of semiconductor packages according to embodiments of the invention.
Figure 2A illustrates a perspective view of a conventional semiconductor package utilizing a single layer metal (SLM) for the top metal.
Figure 2B illustrates a perspective view of a conventional semiconductor package utilizing a dual layer metal (DLM) for the top metal.
Figures 2C, 2D, 2E, and 2F illustrate perspective views of a semiconductor package according to embodiments of the invention.
Figure 3A illustrates a schematic view of a semiconductor packages according to embodiments of the invention.
Figure 3B illustrates a schematic view of support surfaces for receiving the semiconductor packages of Figure 3A.

### DETAILED DESCRIPTION OF THE INVENTION

The present application is directed to a semiconductor package with reduced on-resistance and top metal spreading resistance with application to power transistor packaging. The following description contains specific information pertaining to the implementation of the present invention. One skilled in the art will recognize that the present invention may be implemented in a manner different from that specifically discussed in the present application. Moreover, some of the specific details of the invention are not discussed in order not to obscure the invention. The specific details not described in the present application are within the knowledge of a person of ordinary skill in the art.

The drawings in the present application and their accompanying detailed description are directed to merely exemplary embodiments of the invention. To maintain brevity, other embodiments of the invention, which use the principles of the present invention, are not specifically described in the present application and are not specifically illustrated by the present drawings.

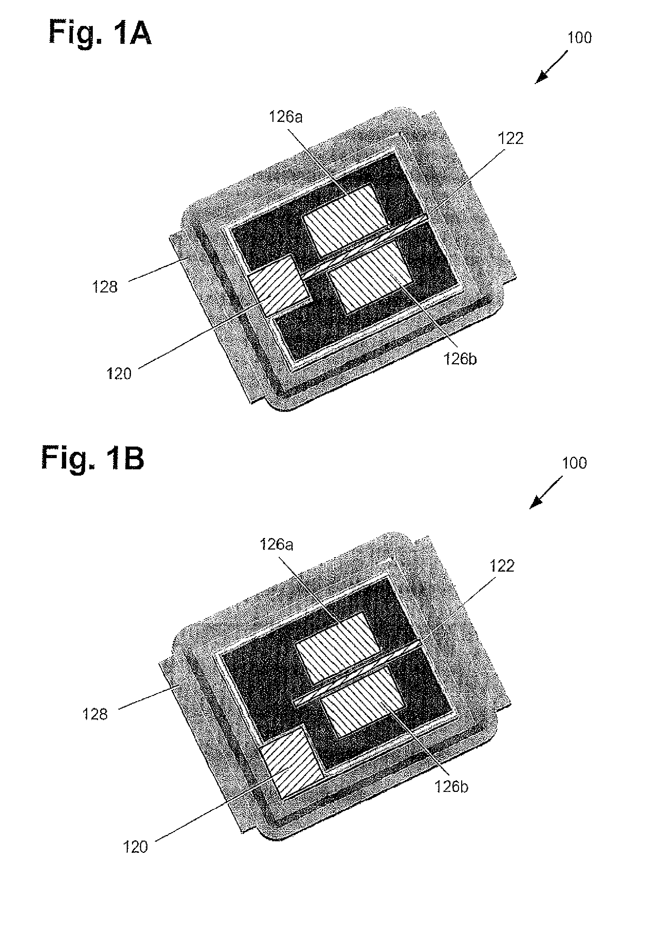

Figure 1A illustrates a perspective view of a conventional semiconductor package. Diagram 100 of Figure 1A shows a package including a conductive clip 128 and a FET device including gate pad 120, gate bus 122, and source pads 126a and 126b. While the examples shown in the Figures use a single FET as the exemplary package device, other device configurations such as diodes, IGBTs, or multiple co-packed devices may also be utilized.

The FET of the package shown in Figure 1A may correspond to the Hex 3 MX die available from International Rectifier. As shown in Figure 1A, the package is configured such that the electrodes on opposite major surfaces are connectable to a planar support surface without a bondwire, as described in U.S. Pat. No. 6,624,522, assigned to International Rectifier, whose disclosure is fully incorporated herein by reference. More specifically, assuming that the opposite major surface of the die (not shown) includes a drain pad that is in contact with the conductive clip 128, all electrodes including the gate from gate pad 120, the source from source pads 126a and 126b, and the drain from conductive clip 128 may be directly mechanically and electrically attached by solder to a planar support surface such as a printed circuit board (PCB) without the use of a bondwire. Such a direct attachment is made possible due to the shape of the conductive clip 128, which includes a flat web portion receiving the device die and a peripheral rim portion extending from an edge of the flat web portion to connect the drain electrode to the planar support surface.

As shown in Figure 1A, gate pad 120 is conventionally positioned in the center of a shorter dimension of the die to facilitate end user integration. Gate pad 120 is also connected to gate bus 122, which runs across the center of the die in the longer dimension. The package shown in Figure 1A may be considered as a control package for a spreading resistance measurement model with the calculated top metal spreading resistance set as 100%. An exemplary spreading resistance measurement model for Figures 1A through 1D may be configured with the following parameters:

**Table 1: Exemplary parameters for a spreading resistance measurement model.**

| **Material** | **Resistivity (Ωm)** | | | **Thickness (µm)** |
|---|---|---|---|---|
| | **X** | **Y** | **Z** | |
| Solder | 1.45 | E-07 | (X, Y, Z) | 90 |
| Aluminum (top metal) | 2.56 | E-08 | (X, Y, Z) | 4 |
| FET channel | ∞ | ∞ | 0.665 | 1.5 |
| Silicon | 1.40 | E-05 | (X, Y, Z) | 200 |
| Die attach | 1.00 | E-06 | (X, Y, Z) | 30 |
| Conductive clip (Copper) | 1.70 | E-08 | (X, Y, Z) | 250 |

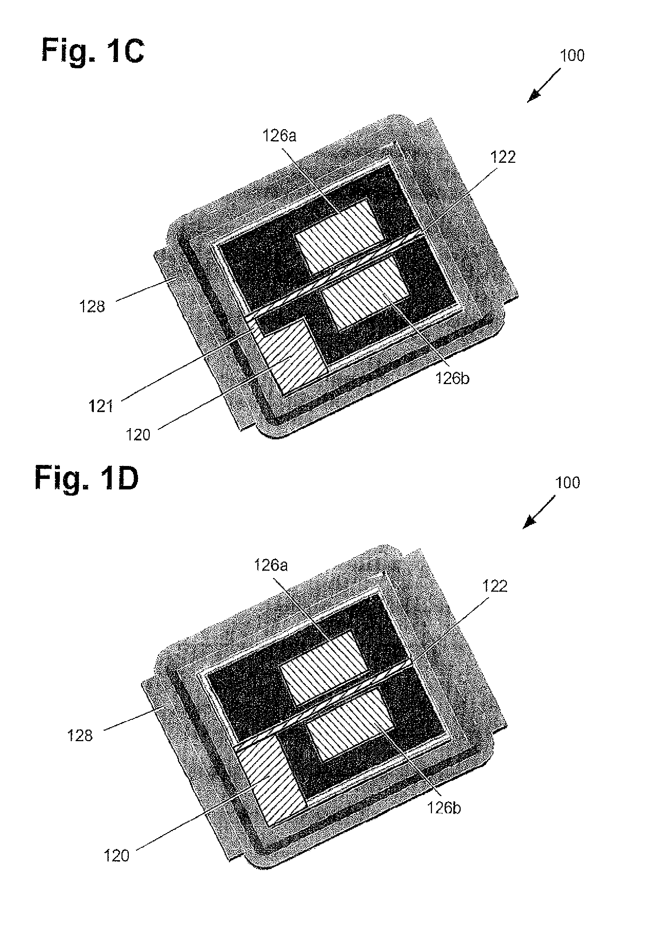

Next, Figures 1B, 1C, and 1D illustrate perspective views of semiconductor packages according to embodiments of the invention. Moving first to Figure 1B, the change affected is the displacement of gate pad 120 from a center position to a corner position on the visible major surface of the die. According to test results of the above measurement model in Table 1 applied to the package configurations of Figures 1A and 1B, the displacement of the gate pad to the corner alone reduces the top metal spreading resistance to approximately 82%, a reduction of approximately 18%.

Moving to Figure 1C, since the displacement of the gate pad 120 in Figure 1B fails to connect the gate pad 120 to the gate bus 122, the package of Figure 1C adds a metal segment 121 to connect gate pad 120 to gate bus 122, which is extended across the die. The measured top metal spreading resistance of the package shown in Figure 1C is also approximately 82% of the measured resistance of the control package.

Moving to Figure 1D, the aspect ratio of gate pad 120 is modified such that gate pad 120 extends at least halfway across a shorter dimension of the visible major surface. In this manner, a direct connection to gate bus 122 is established without the need for metal segment 121 of Figure 1C. The surface area of gate pad 120 between Figure 1C and Figure 1D may remain similar with just the aspect ratio of gate pad 120 modified. Testing of the package in Figure 1D under the above spreading resistance measurement model results in a spreading resistance 78% of the measured resistance of the control package, an improvement of approximately 3% from the design of Figure 1C.

Thus, the results from the above spreading resistance measurement model demonstrate that the positioning of a gate pad in a corner rather than in the center of a shorter dimension of the die may reduce top metal spreading resistance by approximately 18%, and the resizing of the gate pad aspect ratio such that the gate pad extends at least halfway across a shorter dimension of the die may further reduce the top metal spreading resistance by approximately 3%.

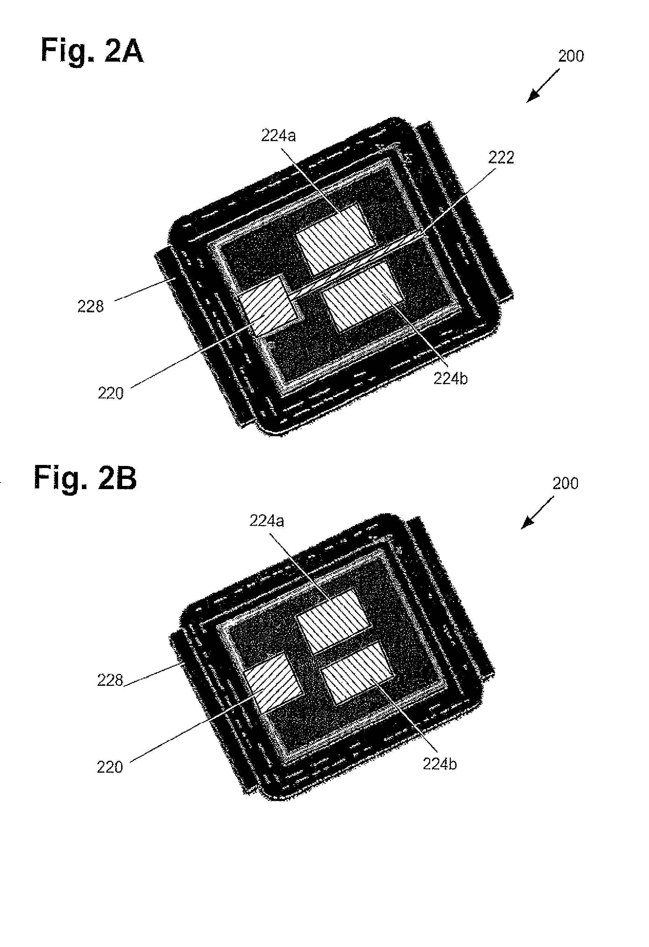

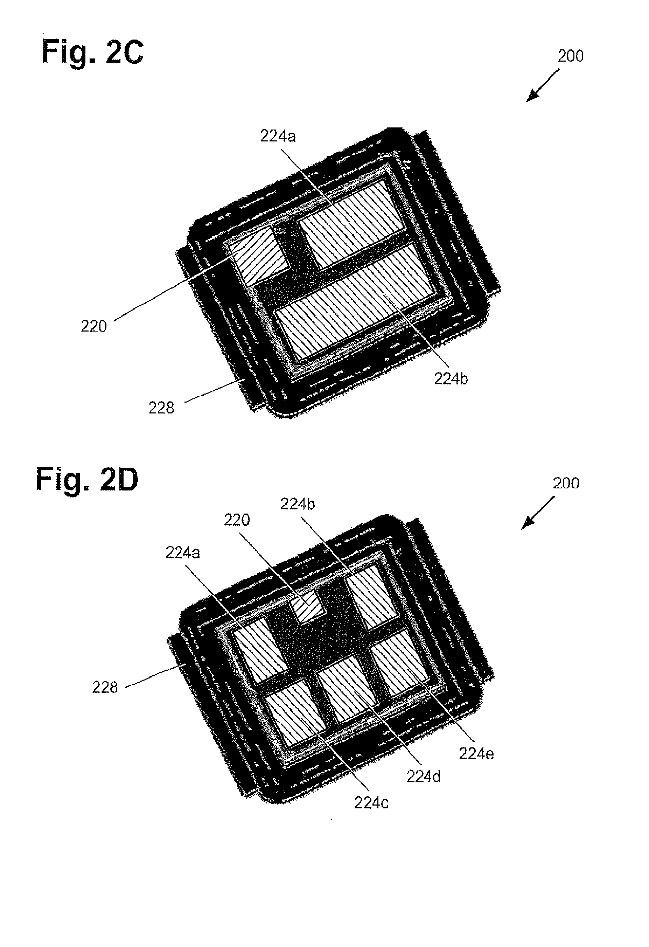

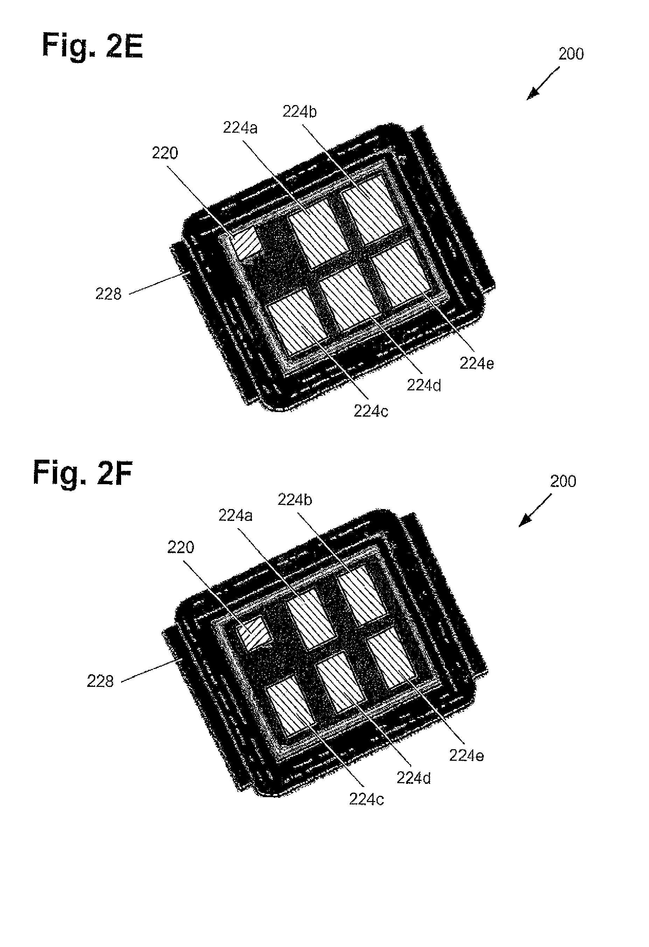

Now that the effects of corner gate pad positioning on top metal spreading resistance are known, the effects of dual layer metal (DLM) top metal and various die pad arrangements may be explored in conjunction with Figures 2A, 2B, 2C, 2D, 2E and 2F. Moving to Figure 2A, Figure 2A illustrates a perspective view of a conventional semiconductor package utilizing a single layer metal (SLM) for the top metal, which may comprise aluminum at a thickness of 0.6 microns. Diagram 200 of Figure 2A includes gate pad 220, gate bus 222, source pads 224a and 224b, and conductive clip 228. Similar to Figure 1A, the semiconductor package shown in Figure 2A may also be used as a test control and may also comprise a Hex 3 MX die available from International Rectifier. Gate pad 220 may have dimensions of 1.01 by 0.91 mm, each of source pads 226a and 226b may have dimensions of 0.82 by 1.40 mm, and gate bus 222 may have a width of 114 microns. An exemplary spreading resistance measurement model for Figures 2A through 2F may be configured with the following parameters:

**Table 2: Exemplary parameters for a spreading resistance measurement model.**

| **Material** | **Resistivity (Ωm)** | | | **Thickness (µm)** |
|---|---|---|---|---|
| | **X** | **Y** | **Z** | |
| Solder | 1.45 | E-07 | (X, Y, Z) | 90 |
| Aluminum (top metal) | 2.56 | E-08 | (X, Y, Z) | SLM: 6 |
| | | | | DLM: 1.5 and 8 |
| FET channel | ∞ | ∞ | 0.00481 | 1.5 |
| | | (R*AA = 10mΩmm²) | | |
| Silicon | 1.40 | E-05 | (X, Y, Z) | 200 |
| Die attach | 1.00 | E-06 | (X, Y, Z) | 30 |
| Conductive clip (Copper) | 1.70 | E-08 | (X, Y, Z) | 250 |

Figures 2C, 2D, 2E, and 2F illustrate perspective views of a semiconductor package according to embodiments of the invention. Moving to Figure 2B from Figure 2A, the semiconductor package now uses dual layer metal (DLM) for the top metal rather than single layer metal (SLM). More specifically, a first metal thickness of 1.5 microns is used for gate pad 220, and a second metal thickness of 8 microns is used for the gate bus which may extend across the longer dimension of each die but is omitted from Figures 2B through 2F for clarity of pad arrangement. Applying the above spreading resistance measurement model to Figures 2A and 2B, the semiconductor device package of Figure 2A exhibits a top metal spreading resistance of 0.143 mΩ and a total device resistance of 1.097 mΩ whereas the semiconductor device package of Figure 2B exhibits a top metal spreading resistance of 0.111 mΩ and a total device resistance of 0.997 mΩ. Accordingly, it can be seen that the model demonstrates that a DLM top-metal configuration reduces both the top metal spreading resistance and the on-resistance compared to a SLM top-metal configuration of the same die.

Moving to Figure 2C from Figure 2B, the semiconductor package now instead uses a corner placement for gate pad 220 and maximizes the surface area of source pads 224a and 224b. More specifically, the surface area of source pad 224a may be increased to 1.19 by 1.99 mm, and the surface area of source pad 224b may be increased to 1.19 by 3.44 mm. Applying the above spreading resistance measurement model to Figure 2C, the semiconductor device package of Figure 2C exhibits a top metal spreading resistance of 0.016 mΩ and a total device resistance of 0.890 mΩ. Thus, it can be seen that the top metal spreading resistance is dramatically reduced to less than 15% of the result obtained by the semiconductor device package of Figure 2B, and the total device resistance is further reduced as well. Accordingly, it can be seen that the model demonstrates that a corner gate pad configuration and a larger surface area for the source pads reduces both the top metal spreading resistance and the on-resistance compared to a conventional centered gate pad configuration and a smaller surface area for the source pads. Unfortunately, the large surface area of source pads 224a and 224b and the unbalanced and asymmetrical pad arrangement may render the device package of Figure 2C unwieldy and prone to serious integration errors when attaching to a support surface.

Thus, moving to Figure 2D from Figure 2C, the semiconductor package reverts to a standard central placement for gate pad 220 and instead uses a plurality of spaced pads 224a, 224b, 224c, 224d and 224e instead of two large pads for the source pads. As shown in Figure 2D, the gate and source pads are arranged in a 2 row by 3 column grid pattern, but the pads could be arranged in any desired fashion such as a 2 row by 2 column grid pattern, a 3 row by 3 column grid pattern, or any another configuration, depending on specific package size and other parameters. The size of gate pad 220 is also reduced to 0.6 by 0.6 mm to provide greater gap clearance from surrounding source pads 224a through 224e. Source pads 224a and 224b are sized 1.19 by 0.719 mm, whereas source pads 224c, 224d, and 224e are sized 1.19 by 0.88 mm. The symmetric and balanced pad arrangement of the semiconductor die and the reasonably sized die pads in Figure 2D facilitates easy integration onto a support surface. Moreover, applying the above spreading resistance measurement model to Figure 2D, the semiconductor device package of Figure 2D exhibits a top metal spreading resistance of 0.011 mΩ and a total device resistance of 0.847 mΩ. Accordingly, it can be seen that the model demonstrates that the balanced spaced pad configuration of the pads in Figure 2D still provides for reduced top metal spreading resistance and on-resistance while retaining the easy integration advantages of conventional package designs.

Moving from Figure 2D to Figure 2E, gate pad 220 is moved to a corner position, and source pads 224a and 224b are resized to the same surface area as source pads 224c, 224d, and 224e. Applying the above spreading resistance measurement model to Figure 2E, the semiconductor device package of Figure 2E exhibits a top metal spreading resistance of 0.015 mΩ and a total device resistance of 0.852 mΩ. While top-metal spreading and on-resistance is modestly increased compared to the results of Figure 2D, the overall top-metal spreading and on-resistance is still greatly reduced compared to the results of Figure 2B. The slight increase may be attributed to the slightly uneven distribution of source pads 224a through 224e on the device die.

Moving from Figure 2E to Figure 2E, source pads 224a through 224e are resized to a smaller surface area of 1.15 by 0.65 mm, providing a larger gap spacing between pads. The larger gap spacing may enable the positioning of a plurality of vias in the support surface receiving the semiconductor device package of Figure 2F. More specifically, after the semiconductor device package is soldered to a planar support surface, vias placed in the planar support surface below and between the pads of the semiconductor device may be utilized. The usage of vias may, for example, provide enhanced electrical and thermal performance for the semiconductor device package. Applying the above spreading resistance measurement model to Figure 2F, the semiconductor device package of Figure 2F exhibits a top metal spreading resistance of 0.024 mΩ and a total device resistance of 0.859 mΩ. While top-metal spreading and on-resistance is modestly increased compared to the results of Figure 2E, the overall top-metal spreading and on-resistance is still greatly reduced compared to the results of Figure 2B. The slight increase may be attributed to the slightly smaller surface area of source pads 224a through 224e on the device die.

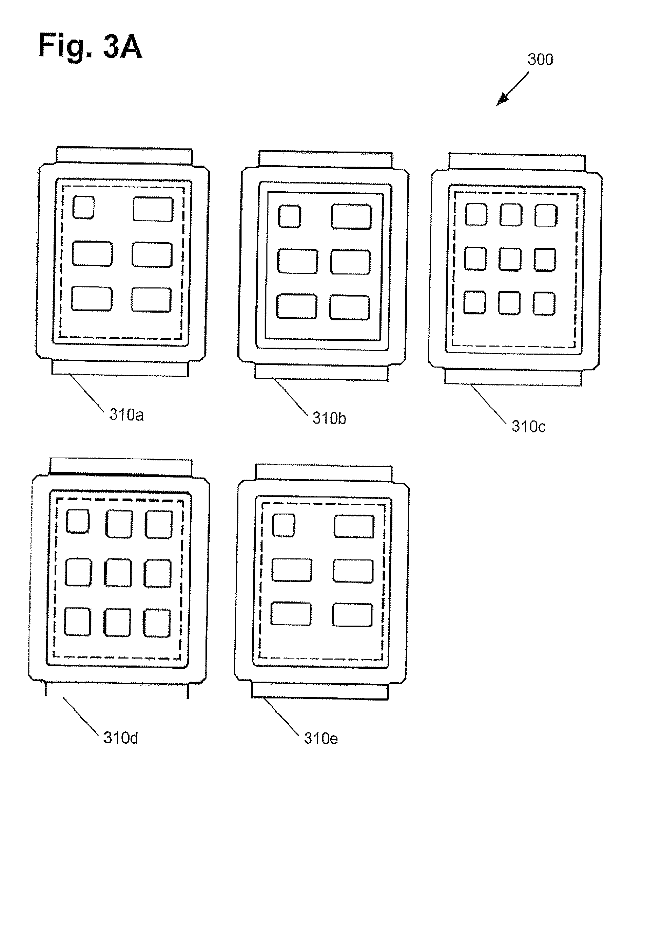

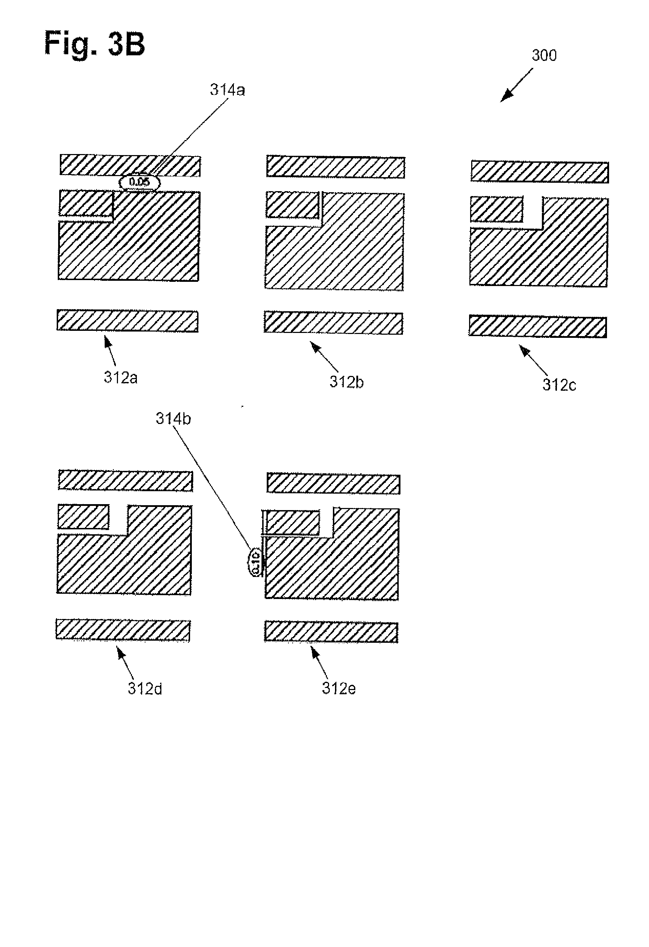

Now that the effects of dual layer metal (DLM) top metal and various die pad arrangements on top-metal spreading resistance and device on-resistance are known, Figures 3A and 3B explore the feasibility of actually manufacturing various die pad arrangements while adhering to best practice design rules and generally accepted manufacturing tolerances for a target design and market.

Figure 3A illustrates a schematic view of a semiconductor packages according to embodiments of the invention. Semiconductor device packages 310a, 310b, 310c, 310d and 310e may each comprise, for example, a DirectFET® medium size package available from International Rectifier, each package having an internal die receiving area of 4.60 by 3.90 mm which is reduced to 4.20 by 3.50 mm to provide sufficient gaps of at least 200 microns between wall edges of the conductive clip. In addition, for manufacturability, pads should be positioned at least 300 microns from the wall edges of the conductive clip. A minimum gap of 0.4 mm in the X and Y-axes and 0.6 mm in the Z-axis between pads may be enforced to enable via placement between pads. Accordingly, semiconductor device packages 310a through 310e show various exemplary die pad configurations following the above design considerations, with semiconductor package devices 310c and 310d directed to pad sizes that are further reduced.

Moving to Figure 3B, Figure 3B illustrates a schematic view of support surfaces for receiving the semiconductor packages of Figure 3A. Support surfaces 312a, 312b, 312c, 312d, and 312e indicate the required copper traces on a planar support surface to receive semiconductor device packages 310a, 310b, 310c, 310d, and 310e respectively of Figure 3A. As shown by the extremely small sizes of gap 314a (0.05 mm) and gap 314b (0.10 mm), the required trace configurations of support surfaces 312a and 312e demand manufacturing precision that might be difficult to achieve and which requires at least 0.15 mm gaps between copper traces. Accordingly, the pad configurations of semiconductor device packages 310a and 310e may be less favored from a manufacturing perspective using present technology, and thus the pad configuration of semiconductor device package 310b may be preferred for ready manufacturing of a corresponding planar support surface receiving the package.

The following embodiments may also be advantageous in the context of the present invention:

A semiconductor package comprising:
a conductive clip having a flat web portion and at least one peripheral rim portion extending from an edge of said flat web portion;
a semiconductor device having a first major surface including a first electrode electrically connected to said web portion and a second major surface including a second electrode and a control electrode;
wherein said control electrode is disposed in a corner of said second major surface;
wherein said at least one peripheral rim portion, said second electrode and said control electrode are solderable to a planar support surface.
Said semiconductor device may comprise a field effect transistor (FET).

Said first electrode may be a drain electrode, said second electrode may be a source electrode, and said control electrode may be a gate electrode.

Said control electrode may extend at least halfway across a shorter dimension of said second major surface.

Said semiconductor package may further comprise a gate bus connected to said control electrode and disposed across a longer dimension of said second major surface.

Said first electrode, said second electrode, and said control electrode may be electrically and mechanically connected to a plurality of traces on said planar support surface using solder.

Thus, a semiconductor device package including a semiconductor device having electrodes on opposite major surfaces connectable to a planar support surface without a bondwire and a control electrode disposed in a corner position for reducing top metal spreading resistance has been described. By moving the control electrode to a corner position, a larger portion of the die surface area may be utilized for the top metal as only two sides rather than three sides of the control electrode must be spaced from source pads, thereby reducing the top-metal spreading resistance. Reducing the size of the gate pad may further increase the area available for the top-metal, also reducing the top-metal spreading resistance. By spacing the source and gate pads apart in a grid fashion, the top-metal spreading resistance may be decreased further while maintaining the easy integration advantages of conventional package designs having balanced and symmetric pad configurations. By increasing such grid spacing, vias may also be provided between the die pads in the planar support surface receiving the semiconductor device package. By carefully observing best practice design rules for manufacturability and reliability, such semiconductor device packages may be manufactured at low cost and high yield efficiency while still improving device performance through reduced device on-resistance resulting from the reduction of top-metal spreading resistance.

From the above description of the invention it is manifest that various techniques can be used for implementing the concepts of the present invention without departing from its scope. Moreover, while the invention has been described with specific reference to certain embodiments, a person of ordinary skills in the art would recognize that changes can be made in form and detail without departing from the spirit and the scope of the invention. As such, the described embodiments are to be considered in all respects as illustrative and not restrictive. It should also be understood that the invention is not limited to the particular embodiments described herein, but is capable of many rearrangements, modifications, and substitutions without departing from the scope of the invention.

## Claims

1. A semiconductor package comprising:
a semiconductor device having a first major surface including a first electrode and a second major surface including a second electrode and a control electrode;
wherein said control electrode is disposed in a corner of said second major surface;
wherein said first electrode, said second electrode, and said control electrode are electrically connectable to a planar support surface without a bondwire.

2. The semiconductor package of claim 1, wherein said second electrode comprises a plurality of spaced pads.

3. The semiconductor package of claim 2, wherein said semiconductor package is soldered to said planar support surface having a plurality of vias disposed between said plurality of spaced pads.

4. The semiconductor package of claim 1, wherein said second electrode and said control electrode form a grid pattern on said second major surface.

5. The semiconductor package of claim 1, wherein said second electrode and said control electrode form a grid pattern on said second major surface comprising at least two rows and at least two columns.

6. The semiconductor package of claim 1, wherein said semiconductor device comprises a field effect transistor (FET).

7. The semiconductor package of claim 1, wherein said first electrode is a drain electrode, said second electrode is a source electrode, and said control electrode is a gate electrode.

8. The semiconductor package of claim 1, wherein said control electrode extends at least halfway across a shorter dimension of said second major surface.

9. The semiconductor package of claim 1 further comprising a gate bus connected to said control electrode and disposed across a longer dimension of said second major surface.

10. The semiconductor package of claim 1, wherein said first electrode, said second electrode, and said control electrode are electrically and mechanically connected to a plurality of traces on said planar support surface using solder.

11. A semiconductor package comprising:
a conductive clip having a flat web portion and at least one peripheral rim portion extending from an edge of said flat web portion;
a semiconductor device having a first major surface including a first electrode electrically connected to said web portion and a second major surface including a second electrode and a control electrode;
wherein said control electrode is disposed in a corner of said second major surface;
wherein said at least one peripheral rim portion, said second electrode and said control electrode are solderable to a planar support surface.

12. The semiconductor package of claim 11, wherein said second electrode comprises a plurality of spaced pads.

13. The semiconductor package of claim 12, wherein said semiconductor package is soldered to said planar support surface having a plurality of vias disposed between said plurality of spaced pads.

14. The semiconductor package of claim 11, wherein said second electrode and said control electrode form a grid pattern on said second major surface.

15. The semiconductor package of claim 11, wherein said second electrode and said control electrode form a grid pattern on said second major surface comprising at least two rows and at least two columns.
